Europäisches Patentamt

European Patent Office

Office européen des brevets

(11) Veröffentlichungsnummer: **0 176 880**
**A2**

# EUROPÄISCHE PATENTANMELDUNG

(21) Anmeldenummer: 85111868.7

(22) Anmeldetag: 19.09.85

(51) Int. Cl.⁴: **H01L 33/00** , H01S 3/045 , H01S 3/19

(30) Priorität: 26.09.84 DE 3435306

(43) Veröffentlichungstag der Anmeldung:
09.04.86 Patentblatt 86/15

(84) Benannte Vertragsstaaten:
DE FR GB

(71) Anmelder: **Siemens Aktiengesellschaft**
**Berlin und München Wittelsbacherplatz 2**
**D-8000 München 2(DE)**

(72) Erfinder: **Westermeier, Heinz**
**Jos.-Kyreinstrasse 9c**
**D-8014 Neubiberg(DE)**

(54) Verfahren zur Herstellung von Laserdioden mit justierter integrierter Wärmesenke.

(57) Die Justierung der aufzubringenden Wärmesenken (40) auf dem mit einer Vielzahl der Halbleiterfunktion versehenen Wafer erfolgt mit Hilfe einer auf dem Wafer (1) aufgebrachten Maske (2), deren Öffnungen (3, 4, 5) für die galvanische Abscheidung des Materials der Wärmesenken (40) reihenweise gegeneinander so versetzt sind, daß optimale Ausnutzung der Waferfläche erreicht ist und dennoch genügend Platz für entlang der Ritzlinie (8, 8') vielfach erfolgenden Ritzens der Waferoberfläche verbleibt.

EP 0 176 880 A2

## Verfahren zur Herstellung von Laserdioden mit justierter integrierter Wärmesenke.

Die vorliegende Erfindung bezieht sich auf eine Laserdiode, wie im Oberbegriff des Patentanspruchs 1 angegeben.

Es ist bekannt, Laserdioden als Einzelbauelemente herzustellen, die jeweils eine Wärmesenke aus gut wärmeleitendem Material, im Regelfall Metall, besitzen. Insbesondere handelt es sich dabei um Streifenlaser-Dioden und um 'buriedlayer'-Laserdioden mit einem Halbleiterkörper, der vorzugsweise mehrere Epitaxieschichten, insbesondere eine Hetero-Schichtstruktur, umfaßt. Eine solche Mehrschichtstruktur wird durch epitaxiale Abscheidung auf einem Substratkörper hergestellt. Die eigentliche laseraktive Zone befindet sich in einer Schicht, die nahe derjenigen Fläche des Schichtaufbaues liegt, die im Substrat gegenüberliegt. In einer Laserdiode mit einem solchen Aufbau wird die bei der Laserstrahlungs-Erzeugung zwangsläufig anfallende Wärme demzufolge nahe dieser dem Substrat abgewandten Oberfläche des Schichtaufbaues erzeugt. Sinnvoll ist es daher, die Wärmesenke auf dieser Oberfläche des Schichtaufbaues anzubringen. Dies wird als 'upside-down'-Technologie bezeichnet. In dieser Technologie ist es erforderlich, die Wärmesenke möglichst exakt auf dem Laserdioden-Element anzubringen, und zwar derart, daß mindestens im Bereich des einen Resonatorspiegels der laseraktiven Zone, nämlich im Bereich desjenigen Spiegels, durch den der nutzbar gemachte Laserstrahl aus der Laserdiode austritt, die Wärmesenke bis höchstens an die Ebene des Spiegels heranreicht, besser noch einige µm zurücktritt. Damit ist gewährleistet, daß der divergent aus der Laserdiode austretende, genutzte Laserstrahl nicht an eine Kante der Wärmesenke anstößt.

Aufgabe der vorliegenden Erfindung ist es, insbesondere für die Massenherstellung derartiger einzelner Laserdioden-Bauelemente eine Maßnahme anzugeben, mit der in einfacher Weise und ohne zumindest wesentlichen Mehraufwand an Material exakt justiert die jeweilige Wärmesenke anzubringen ist.

Diese Aufgabe wird mit den Maßnahmen des Patentanspruchs 1 gelöst. Weitere Ausgestaltungen und Weiterbildungen der Erfindung gehen aus den Unteransprüchen hervor.

Für die Erfindung ist von dem Herstellungsprinzip ausgegangen worden, zunächst eine Vielzahl von Laserdioden-Einheiten innerhalb eines größeren Wafers herzustellen und diesen Wafer dann in prinzipiell bekannter Weise in die Einzel-Bauelemente zu zerbrechen. Für dieses Brechen wird die Ritzmethode unter Verwendung eines Diamanten benutzt. Die entstehenden Bruchflächen sind die Spiegelflächen der einzelnen Resonatoren der einzelnen Laserdioden, wie dies allgemein bekannt ist.

Der Erfindung liegt die weitergehende Idee zugrunde, auch die Wärmesenken bereits auf dem Wafer anzubringen und die exakte Justierung mit Hilfe einer vorzugsweise wieder verwendbaren Maske zu bewerkstelligen. Nach Herstellung des gesamten epitaxialen Schichtaufbaues der Schichtstruktur des Wafers und nach vorzugsweise auf der betreffenden Oberfläche dieser Schichtstruktur ganzflächig aufgebrachter Elektrodenbeschichtung wird diese Oberfläche bzw. diese Elektrodenbeschichtung mit einer Maske überzogen, die vorzugsweise aus Fotolack besteht. In an sich bekannter Weise gibt man der Fotolackschicht eine Maskierungsstruktur, die den vorgesehenen anzubringenden Wärmesenken entspricht. Für eine jede im Wafer vorgesehene Laserdiode erhält diese Fotolackschicht eine Öffnung für galvanisches Aufwachsen des Metalles der zu dieser Diode zugehörigen Wärmesenke.

Wie oben bereits erwähnt, ist es erforderlich, daß zumindest im Bereich des jeweils einen Resonatorspiegels, d.h. der später durch Brechen zu erzeugenden einen Seitenfläche der Waferbruchstücke, die aufgebrachte Wärmesenke auf wenige µm genau zu diesem Spiegel bzw. dieser Seitenfläche justiert ist. Zur Erfindung gehört aber noch der weitere Gedanke, insbesondere zur Materialersparnis diese einzelnen, für die Wärmesenken vorgesehenen Öffnungen der Fotolackmaske in günstiger Weise zu einander anzuordnen bzw. zu verteilen, wobei erfindungsgemäß eine von Reihe zu Reihe versetzte Verteilung und dazu angepaßte Form der Kontur besonders günstig ist.

Nach erfolgtem galvanischen Aufbau der Wärmesenken aller Laserdioden des Wafers wird die Fotolackschicht entfernt und es wird das nacheinander in zwei Koordinatenrichtungen erfolgende Zerbrechen des Wafers in die einzelnen Laserdiodenchips durchgeführt. Damit auch bei großer Anzahl von Laserdioden auf einem einzigen Wafer der Verlauf des Bruches auf die bereits angebrachten Wärmesenken justiert erfolgt, wird nicht nur einmaliges, jeweils am äußeren Rand des Wafers ausgeführtes Ritzen getätigt, sondern es erfolgt jeweils ein mehrfaches Ritzen der Wafer-Oberfläche entlang der geforderten, zwischen den bereits angebrachten Wärmesenken verlaufenden Soll-Bruchkante des Wafers.

Gemäß einer Weiterbildung der Erfindung kann vorgesehen sein, die Fotolackmaske auch zusätzlich mit Justiermarken, insbesondere Justieröffnungen, für das jeweilige Ansetzen des Ritzdiamanten zu versehen. Aufgrund des fotochemischen Herstellungsverfahrens der Öffnungen der Fotolackmaske auf dem Wafer können diese Justiermarken nahezu beliebig genau zu den für die Wärmesenken vorgesehenen Öffnungen justiert angebracht werden, und zwar dies ohne besonderen Aufwand.

Weitere Erläuterungen zur Erfindung gehen aus der anhand der beigefügten Figuren gegebenen weiteren Beschreibung hervor.

Fig.1 zeigt einen Abschnitt eines Halbleiterwafers (bestehend aus Substrat und daraufliegender Epitaxie-Halbleiter-Schichtstruktur) mit auf seiner Fläche angeordneter Fotolackschicht. Diese Fotolackschicht besitzt bereits die Öffnungen für die Wärmesenken und (gemäß einer Weiterbildung) auch Markierungen für das Ritzen.

Fig.2 zeigt eine fertige Laserdiode als Einzelelement.

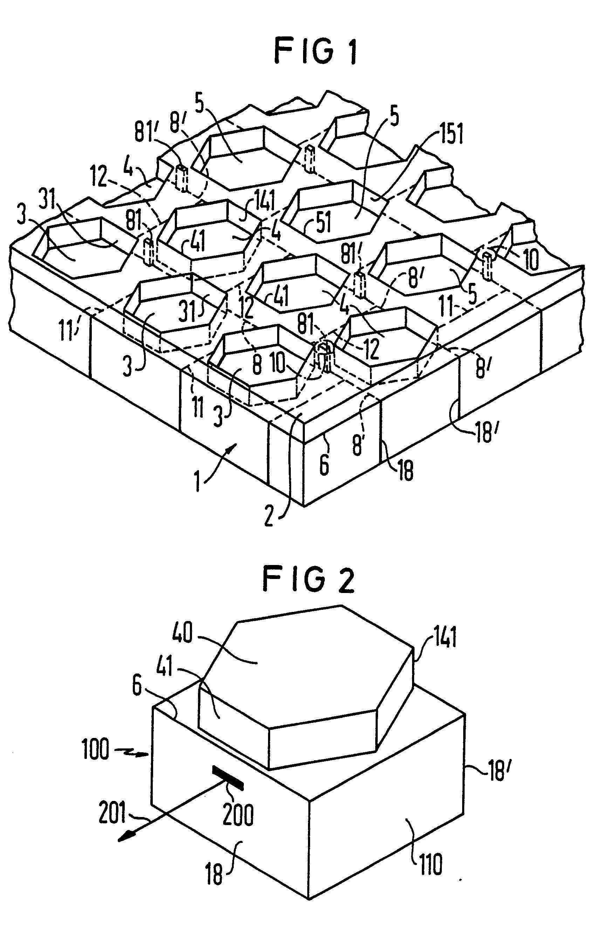

In Fig.1 ist mit 1 der Halbleiter-Wafer und mit 2 die auf der Oberfläche seiner Schichtstruktur befindliche Fotolackschicht bezeichnet. Vorzugsweise hat die Fotolackschicht 2 eine Dicke, die zumindest angenähert der Dicke der herzustellenden einzelnen Wärmesenken ist. Mit 3, 4 und 5 sind jeweilige Öffnungen der Fotolackschicht 2 bezeichnet, die fotolithografisch hergestellt und bis auf die Waferoberfläche bzw. bis auf die auf der Waferoberfläche befindliche Elektrodenbeschichtung 6 herabreichen. Die Öffnungen 3 bilden eine Reihe, die Öffnungen 4 eine zweite Reihe und die Öffnungen 5 eine weitere Reihe, wobei die Öffnungen 3, 4 und 5 ansonsten gleichartig sind bzw. sein können. Das Volumen der Öffnungen 3, 4 und 5 wird nachfolgend galvanisch mit Metall aufgefüllt, wobei dies die jeweilige Wärmesenke der einzelnen Laserdiode ergibt, die aus dem ganzen Wafer noch herauszubrechen ist. Die Öffnungen 3, 4 und 5 sind - wie auch aus der Darstellung der Fig.1 ersichtlich - zueinander angeordnet. Die Öffnungen 3 liegen dicht nebeneinander. Zwischen ihnen befindet sich jedoch noch ein solcher Abstand, daß beim späteren Brechen entlang eines Geradenabschnittes 7, der zwischen den Wärmesenken zweier benachbarter Öffnungen 3 verläuft, nicht auch noch das galvanisch aufgetragene Material (ansonsten miteinander verbundener) Wärmesenken geteilt werden muß. Mit 31 sind Stirnflächen der Öffnungen 3 bezeichnet.

Mit 41 sind den Stirnflächen 31, jedoch versetzt, gegenüberliegende Stirnflächen der Öffnungen 4 bezeichnet. Auf Geraden 8 bzw. 8', die zwischen den Stirnflöchen 31 einerseits und 41 andererseits (bzw. zwischen 141 und 51) verläuft, ist die Bruchkante für den ersten Schritt zur Aufteilung des Wafers in einzelne Barren vorgesehen. Die diesen Bruchkanten 8, 8' entsprechenden Bruchflächen 18, 18' des Wafers sind Spiegelflächen der einzelnen Laserdioden. Bekanntermaßen läßt man die Bruchkanten 8, 8' (und 7) entlang natürlicher Spaltflächen des Kristallmaterials des Wafers 1 verlaufen.

Erfindungsgemäß ist vorgesehen, daß wenigstens die jeweils eine Stirnfläche 31 oder 41 der Öffnungen 3 bzw. der Öffnung 4 so justiert ist, daß die Bruchkante 8 in einem Abstand von etwa 0 bis 3 µm, insbesondere in einem Abstand von etwa 1 bis 2 µm, von der vorgesehenen Bruchkante 8 verläuft. An einer solchen Stirnfläche 31 bzw. 41 hat die nach der Erfindung aufgebrachte Wärmesenke eine solche exakte Justierung, daß einerseits (noch) maximale Kühlwirkung auch im Bereich der betreffenden Spiegelfläche der laseraktiven Zone der Laserdiode vorliegt und andererseits das Vorhandensein bzw. die der Stirnfläche 31 entsprechende Vorderkante der Wärmesenke der Laserdiode die Aussendung der Laserdiode durch die betreffende Spie gelfläche der Bruchfläche 18 dieser Laserdiode nicht beeinträchtigt. Sinngemäß das gleiche gilt für die Justierung der die Stirnfläche 41 der Öffnung 4 entsprechenden Kante der betreffenden Wärmesenke in bezug auf wiederum diese Bruchkante 8. Eine solche wie voranstehend beschriebene Justierung kann sinngemäß auch zwischen (versetzt) gegenüberliegenden Stirnflächen 141 und 51 von Öffnungen 4 und 5 im Hinblick auf die Bruchkante 8' erreicht werden.

Es wurde bereits oben erwähnt, daß es nicht in allen Fällen notwendig ist, daß bei einer Laserdiode diese exakte Justierung auch für die jeweils zweite Spiegelfläche des optischen Resonators dieser Laserdiode erfüllt sein muß, nämlich wenn durch diese zweite Spiegelfläche hindurchtretende Laserstrahlung als solche nicht genutzt wird. Angenommen es handelt es sich dabei um den Stirnflächen 41 entsprechende Flächen der einzelnen Chips, so könnten die Stirnflächen 41 auch auf der Bruchkante 8 enden bzw. sogar auch geringfügig überstehen, nämlich solange ein Überstehen des Materials der Wärmesenke das exakte Spalten des Halbleiterwafers entlang der vorgegebenen Bruchkante noch nicht beeinträchtigt.

Wie aus der Darstellung zur Erfindung ersichtlich, ist (jeweils) ein seitlicher Versatz der Öffnungen 4 der einen Reihe gegenüber den Öffnungen 3 und 5 der benachbarten Reihen vorgesehen. Diese Aufteilung wird zweckmäßigerweise für die ganze Waferoberfläche angewendet. Der Versatz beträgt die halbe Breite eines fertigen Laserdiodenchip. Da außerdem - wie aus Fig.1 ersichtlich - die Wärmesenken (in Fig.1 dargestellten Öffnungen 3, 4 und 5) an ihren diametral gegenüberliegenden Ecken abgeschnitten sind, ergeben sich diagonal gesehen größere Zwischenräume zwischen den einzelnen Öffnungen 3, 4 und 5 bzw. den erzeugten Metallkörpern der Wärmesenken. Mit 10 ist an zwei Stellen ein solcher größerer Zwischenraum hervor gehoben. Auf die weggefallenen Ecken der Wärmesenken kann leicht verzichtet werden, da sie ohnehin außerhalb des optimalen Kühlungsbereiches der Laserdiode liegen. Diese Zwischenräume 10 sind jedoch im Rahmen der Erfindung insoweit von großer Bedeutung, daß sie Raum geben, um zwischen den gegeneinander versetzt angeordneten Wärmesenken 3 und 4 bzw. 4 und 5 (u.s.w.) einzelne Abschnitte von Ritzungen entlang der geforderten Bruchkante 8, 8' zu erzeugen. Bei nicht ganz exakter Justierung der Fotolackmaske 2 bzw. ihrer Öffnungen 3, 4 und 5 zur jeweiligen Kristallachsenrichtung des Wafers 1 kann es dann zwar zu gelegentlichem Versatz innerhalb der Kristallebenen entlang der Bruchfläche 18 kommen, was jedoch höchstens zu einzelnen Ausschuß-Laserdioden führt. Generell ist mit dieser erfindungsgemäß vorgesehenen Maßnahme gewährleistet, daß für die größte Anzahl der einzelnen entstehenden Laserdiodenchips die oben angegebene jeweilige exakte Justierung der Wärmesenke zur spiegelnden Kristall-Spaltfläche des Chips gewährleistet ist.

Mit dem Brechen entlang der Bruchkanten 8, 8' ... entstehen Barren mit linearer Anordnung von Laserdiodenchips, nämlich einerseits mit den mit 3 bezeichneten Wärmesenken, andererseits mit den mit 4 bezeichneten Wärmesenken und weiter mit den mit 5 bezeichneten Wärmesenken, und so weiter. Diese einzelnen Barren werden dann entlang der angedeuteten Bruchkanten 11 und 12 voneinander getrennt, wobei es auf deren Justierung nicht wesentlich ankommt.

Bekanntermaßen wird das Anritzen des Kristallmaterials für das Entstehen der Bruchkanten 8, 8' (11, 12 ...) durch entsprechenden mechanischen Vorschub einer mit einem Ritzdiamanten ausgestatteten Vorrichtung durchgeführt. Bei der Erfindung kann aber gemäß einer Weiterbildung vorgesehen sein, daß in der Fotolackschicht zusammen mit und justiert zu den zu den Öffnungen 3, 4 und 5 Öffnungen 81, 81' (von denen jeweils nur eine der Übersichtlichkeit halber dargestellt ist) vorgesehen sind, die zur späteren Justierung der Ritzabschnitte der Bruchkanten 8, 8' nutzbar gemacht werden. Durch entsprechende Maßnahmen ist bewirkt, daß in diesen Öffnungen keine Abscheidung des Materials der Wärmesenken 3, 4, 5 ... erfolgt.

Fig.2 zeigt ein Einzelchip 110 einer Laserdiode bzw. eine Laserdiode 100 als Einzelbauelement mit erfindungsgemäß angebrachter und erfindungsgemäß justierter Wärmesenke 40. Die übrigen Bezugzeichen beziehen sich darauf, daß diese Laserdiode 100 aus einem Barren hergestellt ist, dessen Wärmesenken mit den Öffnungen 4 hergestellt worden sind. Mit 200 ist auf einen Austrittbereich von in der Diode 100 erzeugten Laserstrahlung 201 hingewiesen.

## Ansprüche

1. Verfahren zur Herstellung von Laserdioden mit integrierter Wärmesenke, wobei diese Wärmesenke ein auf dem Halbleiterkörper nahe der laseraktiven Zone und damit nahe den Resonatorspiegeln angebrachter Körper aus gut wärmeleitendem Material ist und die Laserdiode als Einzelbauelement aus einem größeren Wafer durch Ritzen und Brechen gewonnen worden ist, **gekennzeichnet** dadurch , - daß der bereits mit den Laserfunktionen der Einzelbauelemente ausgestattete Halbleiter-Wafer (1) mit einer Maskierungsschicht (2) bedeckt wird, die bis auf den Wafer (1) herabreichende Öffnungen (3, 4, 5) aufweist, - wobei die Wahl der Anordnung dieser Öffnungen (3, 4, 5) zueinander so getroffen wird, daß die Öffnungen (3, 5) jeweils in einer sich in einer Richtung quer zu den Richtungen der vorgegebenen Laserresonatoren erstreckenden Reihe (Fig.1) angeordnet sind, - wobei die Öffnungen (3, 3, 3 ... bzw. 5, 5, 5 ...) um ein halbes Teilungsmaß gegenüber den entsprechenden Öffnungen (4, 4, 4 ...) der jeweils unmittelbar benachbarten Reihe angeordnet worden sind, so daß diese Versetzung der Öffnungen (3, 4, 5) von Reihe zu Reihe abwechselnd ist (Fig.1), - daß die Öffnungen (3,4, 5) mit dem wärmeleitenden Material der vorgesehenen Wärmesenke (40) gefüllt werden, - daß in Parallelrichtungen (8, 8') zu diesen Reihen der Öffnungen (3 bzw. 4 bzw. 5) die Oberfläche des Wafers (1) justiert zwischen diesen Reihen geritzt wird und der Wafer (1) entlang dieser Ritzlinien (8, 8' in einzelne Barren gebrochen wird, und - daß die Einzelelemente (Fig.2) durch Ritzen und Brechen entlang zwischen den einzelnen Funktionen des Wafers (1) verlaufenden Linien (11, 12) gebrochen werden.

2. Verfahren nach Anspruch 1, **gekennzeichnet**dadurch, daß in der Maske (2) zusätzliche Öffnungen (81, 81') vorgesehen werden, die zur Justierung einzelner Ritzstellen der Ritzlinien (8, 8') verwendet werden, wobei diese zusätzlichen Öffnungen (81, 81') in Flächenbereichen (10) der Maske (2) positioniert werden, die frei gehalten worden sind von einander versetzt gegenüberstehenden Randseitenflächen (31-41 bzw. 141-51) der Öffnungen (3-4 bzw. 4-5) jeweils benachbarter Reihen der Öffnungen für die Wärmesenken (40).

3. Verfahren nach Anspruch 1 oder 2, **gekennzeichnet** dadurch , daß zwischen der Maske (2) und der Oberfläche des Wafers (1) auf der Oberfläche des Wafers eine Elektrodenschicht (6) aufgebracht worden ist.

4. Verfahren nach einem der Ansprüche 1, 2 oder 3, **gekennzeichnet** dadurch , daß das wärmeleitende Material der Wärmesenken (40) galvanisch in den Öffnungen (3, 4, 5) der Maske (2) aufgewachsen wird.

5. Verfahren nach einem der Ansprüche 1 bis 4, **gekennzeichnet** dadurch , daß das Material der Maske (2) vor dem Ritzen der den Reihen parallelen Ritzlinien (8, 8') von der Oberfläche des Wafers entfernt wird.

6. Verfahren nach einem der Ansprüche 2 bis 5, **gekennzeichnet** dadurch , daß die zusätzlichen Öffnungen (81, 81') der Maske (2) während des Aufsetzens des Ritzdiamanten als Führung verwendet werden.

7. Verfahren nach einem der Ansprüche 1 bis 7, **gekennzeichnet** dadurch , daß als Material für die Maske (2) Fotolack verwendet wird.

# FIG 1

# FIG 2